# EUROPÄISCHE PATENTSCHRIFT

(11) **EP 1 039 304 B1**
(45) Veröffentlichungstag und Bekanntmachung des Hinweises auf die Patenterteilung: **26.10.2005**
(21) Anmeldenummer: 00100471.2
(22) Anmeldetag: 11.01.2000
(51) Int. Cl.: G01R 15/14, G01R 19/25

(54) **Messverfahren für eine Hochspannungsdurchführung und geeignete Messanordnung**
Measuring process for a high voltage lead-through and related device
Méthode de mesure d'une traversée de haute tension et dispositif associé

(30) Priorität: 19.03.1999 DE 19912410
(43) Veröffentlichungstag der Anmeldung: 27.09.2000
(73) Patentinhaber: Maschinenfabrik Reinhausen GmbH, 93059 Regensburg (DE)
(72) Erfinder: Viereck, Karsten, Dr.-Ing., 93128 Diesenbach (DE); Ermisch, Jochen, Dr.-Ing., 01445 Radebeul (DE)

(56) Entgegenhaltungen:
- EP-A- 0 437 861
- EP-A- 0 871 036
- US-A- 5 144 226

## Beschreibung

Die Erfindung betrifft ein Meßverfahren gemäß dem Oberbegriff des ersten Patentanspruches sowie eine Meßanordnung gemäß dem Oberbegriff des nebengeordneten zweiten Patentanspruches.

Aus der DE 195 19 230 C1 sind ein Überwachungsverfahren und eine Überwachungsanordnung zur Überwachung einer Kondensatordurchführung für hohe Spannungen bekannt. Dabei werden Teilspannungen abgegriffen, auf Änderungen überwacht, der zeitliche Abstand zwischen zwei Änderungen erfaßt und aus der Häufigkeit der Teilspannungsänderungen ein Fehlersignal ermittelt, das in Relation zu den stattgefundenen Durchschlagsereignissen steht. Dazu ist eine Überwachungsanordnung vorgesehen, in der dann je nach Häufigkeit der Spannungsänderungen ein entsprechend gewichtetes Melde- oder Fehlersignal generiert wird.

Aus der Veröffentlichung "Fact Sheet CE Component Products, Bushing Potential Device" von General Electric ist weiterhin auch bereits eine Meßanordnung an einer Hochspannungsdurchführung bekannt. Dabei wird ein Verfahren zur Spannungsmessung beschrieben, das es ermöglicht, ohne konventionelle, induktive Spannungswandler das Hochspannungspotential zu bestimmen. Bei der dabei verwendeten Anordnung sind eine neben der eigentlichen Hochspannungsdurchführung als wesentliche Bauteile ein Unterspannungskondensator und zwei Anpaßtransformatoren, ein sog. "Stepdown Transformer" und ein sog. "Adjustment Transformer", vorhanden, die eine Anpassung der Meßanordnung an die jeweilige Durchführung durch Resonanzmessung zum Abgleich des Phasenwinkeis gestatten. Darüber hinaus dienen sie zur Bereitstellung der jeweiligen Bürdenleistung.

Besonders nachteilig an dieser bekannten Meßanordnung sind dabei die notwendigen induktiven Bauteile, die das Ganze groß, schwer und teuer machen. Aus den Bildern in der o.a. Veröffentlichung ist zu entnehmen, daß die jeweiligen Meßanordnungen als große Kästen außen an jeder Phase des Transformators angeordnet sind. Nach Angaben des Herstellers sind die Anordnungen jeweils 63.5 cm (25 Zoll) hoch und wiegen jeweils 158.75 kg (350 Pfund) Es liegt auf der Hand, daß solche Dimensionen für viele Anwendungsfälle indiskutabel sind. Besonders gravierend wird dieser Nachteil, wenn man berücksichtigt, daß die hohe Bürdenleistung, für deren Bereitstellung die voluminösen Bauteile in erster Linie notwendig sind, in vielen Fällen, in denen eine nachfolgende computergestützte Auswertung bzw. Weiterverarbeitung der Meßsignale erfolgt, gar nicht erforderlich ist.
Ein weiterer Nachteil der bekannten Anordnung ist, daß lediglich der Effektivwert der Spannung ermittelt wird, Aussagen über die in einem bestimmten Meßintervall aufgetretenen transienten Spannungsvorgänge hingegen nicht möglich sind.

Aufgabe der Erfindung ist es demnach, ein gattungsgemäßes Meßverfahren und eine geeignete Meßanordnung anzugeben, die ganz ohne induktive Bauteile auskommt, zudem klein, leicht und preiswert ist. Weiterhin sollen das erfindungsgemäße Meßverfahren und die erfindungsgemäße Meßanordnung auch auf gleichermaßen einfache Weise eine Spitzenspannungsmessung gestatten.

Diese Aufgabe wird durch ein Meßverfahren für eine an einer Hochspannungsdurchführung eines Transformators anliegende Spannung, von der für jede Phase über einen kapazitiven Hochspannungsteiler jeweils eine Teilspannung als Eingangsspannung abgegriffen wird, mit folgenden Merkmalen gelöst:

Zunächst wird die Eingangsspannung einer Pegelanpassung mit nachfolgender Spannungsbegrenzung unterworfen.
Nachfolgend erfolgt eine Potentialtrennung und anschließend eine parallele Weiterverarbeitung des Wertes der Eingangsspannung in zwei getrennten und unabhängigen Kanälen.
Anschließend erfolgt im ersten Kanal eine Betragsbildung des Wertes der Eingangsspannung, dieser Wert wird anschließend einer Sample- and Hold-Schaltung zugeführt, die ihrerseits einen Stromquellenschaltkreis ansteuert, derart, daß der Ausgangsstrom dieses Stromquellenschaltkreises einen Wert ergibt, der proportional dem Spitzenwert der Eingangsspannung ist.
Im zweiten Kanal erfolgt eine Gleichrichtung, der erhaltene Wert der Eingangsspannung steuert einen weiteren Stromquellenschaltkreis an, derart, daß der Ausgangsstrom dieses weiteren Stromquellenschaltkreises einen Wert ergibt, der proportional dem Effektivwert der Eingangsspannung ist.

Die Aufgabe wird weiterhin gelöst durch eine Meßanordnung zur Durchführung dieses Verfahrens:
Es ist eine Eingangsschaltung vorgesehen, die auf an sich bekannte Weise zur Pegelanpassung und Spannungsbegrenzung dient; der Ausgang dieser Eingangsschaltung führt zu Mitteln zur Potentialtrennung, der Ausgang der Mittel zur Potentialtrennung wiederum zu zwei getrennten parallelen Verarbeitungskanälen.
Der erste Verarbeitungskanal weist Mittel zur Betragsbildung auf, deren Ausgang mit dem Eingang einer Sample- and Hold-Schaltung in Verbindung steht, wobei der Ausgang der Sample- and Hold-Schaltung an den Eingang eines Stromquellenschaltkreises geschaltet ist, dessen Ausgangsstrom einen Wert darstellt, der proportional zum Spitzenwert der Eingangsspannung ist.
Der zweite Verarbeitungskanal weist Mittel zur Gleichrichtung auf, deren Ausgang an den Eingang eines weiteren Stromquellenschaltkreises geschaltet ist, dessen Ausgangsstrom einen Wert darstellt, der proportional zum Effektivwert der Eingangsspannung ist.
Nach einer vorteilhaften Weiterbildung der Erfindung wird ein Isolationstrennverstärker als Mittel zur Potentialtrennung benutzt.

Beim erfindungsgemäßen Meßverfahren wird an einem Hochspannungsteiler ein elektrisches Signal abgegriffen. Anschließend erfolgt eine Pegelanpassung und im Anschluß daran eine Spannungsbegrenzung, danach eine Potentialtrennung.
Das elektrische Signal vom Hochspannungsteiler wird erfindungsgemäß parallel auf zweierlei Weise weiterverarbeitet: Es dient sowohl zur Ermittlung des Effektivwertes der Spannung als auch zur Ermittlung des Spitzenwertes der Spannung.
Im ersten Kanal wird nachfolgend eine Betragsbildung vorgenommen. Dieser Wert dient zur Ansteuerung einer nachfolgenden Sample- and Hold-Schaltung, die ihrerseits einen Stromquellenschaltkreis ansteuert. Der Ausgangsstrom dieses Schaltkreises ergibt einen Wert, der proportional dem Spitzenwert der Eingangsspannung ist. Der zweite Meßkanal realisiert die Ermittlung des Effektivwertes der Eingangsspannung auf an sich bekannte Weise.

Die erfindungsgemäße Meßanordnung weist mehrere Baugruppen auf: Eine Eingangsschaltung zur Verarbeitung der Eingangssignale, einen nachgeordneten Trennverstärker, von dem die Signale sowohl zu einer Schaltung zur Ermittlung des Effektivwertes als auch zu einer Schaltung zur Ermittlung des Spannungsspitzenwertes geführt wird, eine Speicher- und Rücksetzschaltung sowie eine Stromversorgungsschaltung.

Insgesamt sind das erfindungsgemäße Meßverfahren und die erfindungsgemäße Meßanordnung besonders geeignet zur Umsetzung von an einem kapazitiven Teiler anliegender Spannung in jeweils einen dem Effektivwert dieser Spannung und einem dem Spitzenwert dieser Spannung entsprechenden Ausgangsstrom. Gespeichert wird dabei der größte Betrag der auftretenden Spitzenspannung während eines Meßintervalls. Über eine Rücksetzung kann dabei auf einfache Weise die Dauer des jeweils gewünschten Meßintervalles bestimmt werden, indem ein Spitzenwertspeicher zurückgesetzt wird.
Das erfindungsgemäße Meßverfahren und die entsprechende Meßanordnung eignen sich damit zum Anschluß von weiteren Überwachungsbaugruppen von Transformatordurchführungen oder zur Spannungsmessung mittels kapazitiver Hochspannungsteiler.

Die Erfindung soll nachfolgend beispielhaft noch näher erläutert werden.

Es zeigen:
- Fig. 1: eine schematische Darstellung des erfindungsgemäßen Meßverfahrens
- Fig. 2: ein Blockschaltbild einer erfindungsgemäßen Meßanordnung
- Fig. 3: die Eingangsschaltung daraus
- Fig. 4: die Speicher- und Rücksetzschaltung daraus
- Fig. 5: die Ausgangsschaltung daraus im Ausschnitt
- Fig. 6: die Stromversorgungsschaltung daraus
- Fig. 7: einen Rücksetzimpuls für die Messung des Spannungsspitzenwertes.

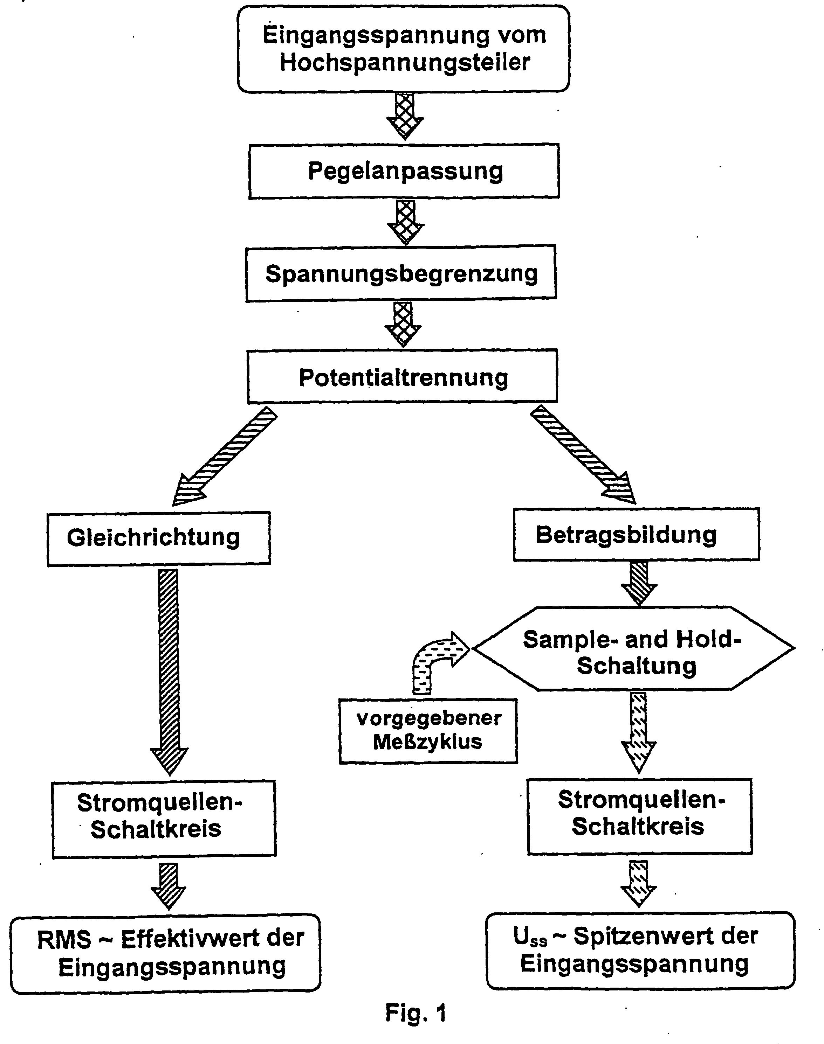

Die wesentlichen Schritte des erfindungsgemäßen Meßverfahrens sind in Fig. 1 schematisch gezeigt. Über einen nicht dargestellten Hochspannungsteiler wird eine Eingangsspannung abgegriffen und einer Pegelanpassung sowie einer Spannungsbegrenzung unterworfen. Dies geschieht als EMV-Schutz, d.h. Schutz vor Überspannungen, die den Eingangskreis der nachfolgenden Baugruppe gefährden können. Nachfolgend erfolgt eine Gleichrichtung dieses solcherart veränderten Eingangssignales. Das im Ergebnis der Gleichrichtung erhaltene Signal, hier als true RMS bezeichnet, wird wiederum nachfolgend weiterverarbeitet. Zum einen steuert es direkt einen Stromquellenschaltkreis an. Das Ausgangssignal ergibt dann auf an sich bekannte Weise einen Strom, der dem Effektivwert der gemessenen Spannung proportional ist. Zum anderen erfolgt zunächst einmal eine Betragsbildung, danach wird das Signal einer Sample- and- Hold-Schaltung zugeführt, die wiederum einen weiteren Stromquellenschaltkreis ansteuert. An dessen Ausgang kann ein dem Betrag des Spitzenwertes der Eingangsspannung proportionaler Strom entnommen werden. Sample- and- Hold-Schaltungen sind dabei per se bekannte Abtast-Halte-Glieder, wie sie beispielsweise in Tietze/Schenk: Halbleiter-Schaltungstechnik, 7. Auflage, Springer-Verlag Berlin, N.Y., Heidelberg, Tokyo, 1985, S.733 ff. beschrieben sind. Dabei soll die Ausgangsspannung der Schaltung im eingeschalteten Zustand der Eingangsspannung folgen. In dieser Betriebsart verhält sie sich also wie ein Analogschalter. Im ausgeschalteten Zustand soll jedoch die Ausgangsspannung nicht Null werden, sondern es soll die Spannung im Ausschaltzeitpunkt gespeichert werden. Zentrales Bauteil einer solchen Sample- and Hold-Schaltung ist dabei ein Kondensator, der die erforderliche Speicherfunktion übernimmt. Wenn der Schalter in der Schaltung geschlossen ist, lädt sich der Kondensator auf die maximale Eingangsspannung auf. Wenn der Schalter geöffnet ist, soll die Spannung am Kondensator möglichst lange unverändert bleiben. Näheres dazu ist in der o.a. Veröffentlichung erläutert. Es ist bei solchen Schaltungen jedoch erforderlich, von außen ein Signal vorzugeben, mit der das jeweilige Meßintervall festgelegt wird. Dies ist in Fig. 1 durch den von links kommenden Pfeil dargestellt. Zum Hintergrund dazu: Die an sich bekannte Messung des Effektivwertes, die in Fig. 1 in der linken Spalte schematisch dargestellt ist, vollzieht sich selbsttätig in Abhängigkeit der Frequenz der zugrundeliegenden Spannung, d.h. deren Nulldurchgängen. Für die in der rechten Spalte dargestellte Erfassung des Spitzenwertes hingegen ist es erforderlich, von außen das jeweilige Meßintervall, während dessen der Spitzenwert ermittelt werden soll, zu definieren. Dies wird weiter unten noch näher erläutert werden.
In der DD 266 895 ist bereits eine andere Einrichtung zur Messung und Erfassung von Größen in Hochspannungsnetzen bekannt, die ebenfalls eine zwischengeschaltete Sample- and Hold-Schaltung aufweist.

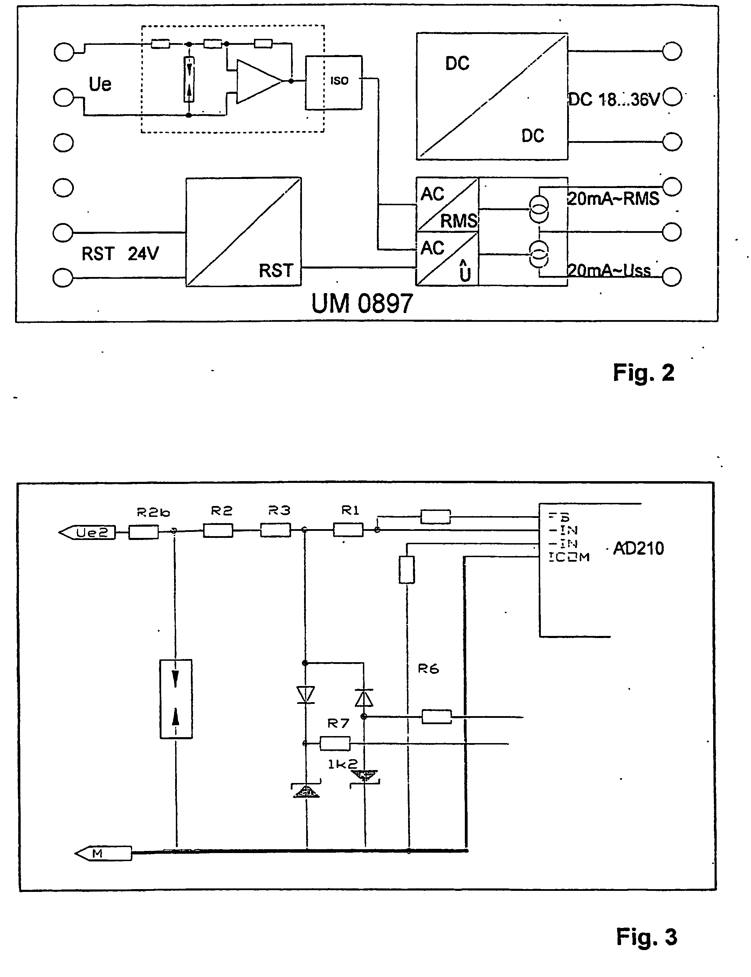

Fig. 2 zeigt eine erfindungsgemäße Meßanordnung in schematischer Darstellung.
Es sind im wesentlichen vier Baugruppen zu erkennen: Oben links eine Eingangsschaltung, darunter eine Rücksetzschaltung, die als Ausgangssignal einen Rücksetzimpuls für die Sample- and- Hold-Schaltung erzeugt. Rechts oben ist die Spannungsversorgung der gesamten Anordnung angedeutet und darunter befindet sich der Teil der eigentlichen Signalverarbeitung, der seinerseits auch die bereits beschriebene Sample- and- Hold-Schaltung sowie eine Ausgangsschaltung aufnimmt.

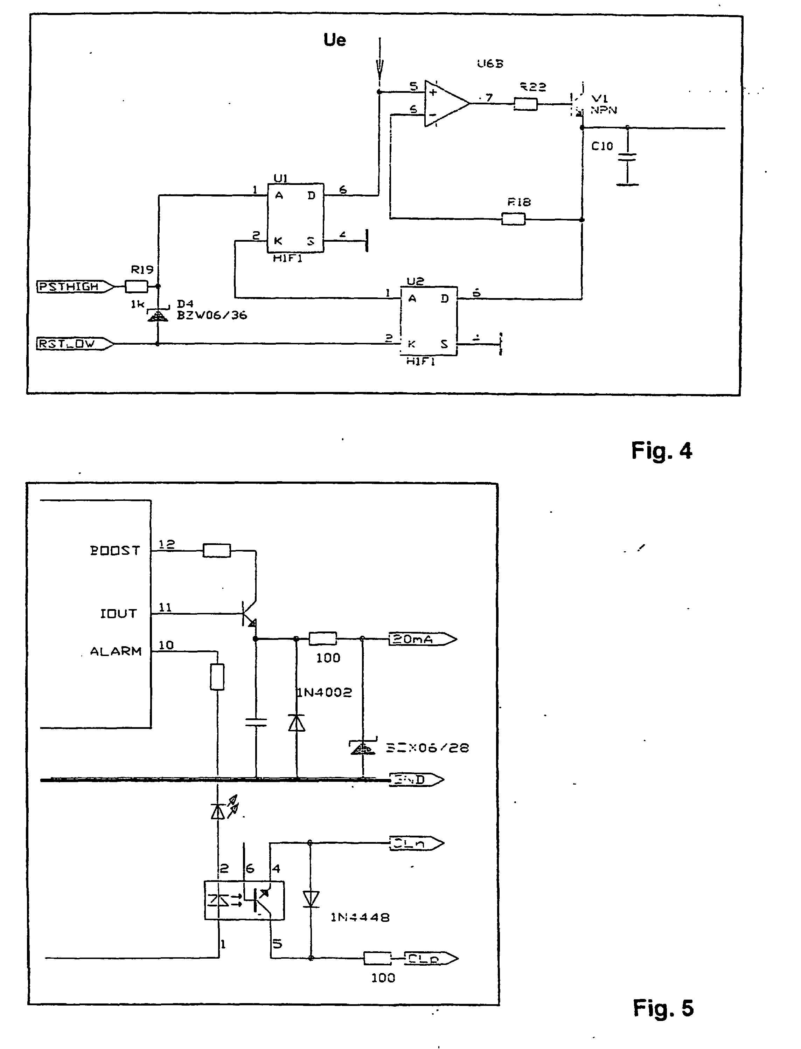

Die Figuren 3 bis 6 zeigen Teile der Meßanordnung noch mehr im Detail.
Figur 3 zeigt die Eingangsschaltung. Der Eingangswiderstand der Eingangsschaltung beträgt z.B. 1 MΩ und berechnet sich aus der Summe der Widerstände R1, R2, R2a und R3. Nach dem Widerstand R2a ist ein Gasableiter mit einer Zündspannung von z.B. 350 V angeordnet. Ein weiterer Schutz gegen Impulsspannungen wird durch ein Diodennetzwerk vor dem nachgeschalteten Isolationstrennverstärker ISO realisiert.
Als Isolationsverstärker wird beispielsweise der "3-Port- Isolation Amplifier AD 210" der Fa. Analog Devices, USA verwendet. Nähere Angaben dazu finden sich in der entsprechenden Firmenschrift, der US-Patentschrift 4.703.283. Der Ausgang des Isolationstrennverstärkers führt, wie bereits erläutert und aus Fig. 2 ersichtlich, zu zwei getrennten Verarbeitungsteilen. Im oberen in Fig. 2 dargestellten Teil wird eine Gleichrichtung durchgeführt und das Signal dann in einen Stromquellenschaltkreis eingespeist. Die Gleichrichtung kann besonders vorteilhaft durch einen "Low Cost, Low Power; True RMS-to-DC Converter AD736" der Fa. Analog Devices, USA erfolgen. Näheres dazu ist den entsprechenden Firmenunterlagen zu entnehmen. Im unteren in Fig. 2 dargestellten Teil ist - wiederum nach der auf gleiche Weise ablaufenden Gleichrichtung - die bereits beschriebene Sample- and Hold- Schaltung vorgesehen. Eine spezielle Ausführungsform einer solchen Schaltung, auch als Speicher- und Rücksetzschaltung bezeichnet, ist in Fig. 4 dargestellt. Sie weist einen Operationsverstärker U6B sowie einen Speicherkondensator C10 auf. Dieser Speicherkondensator C10 wird auf den Spitzenwert der angelegten Wechselspannung aufgeladen. Parallel dazu ist ein optisch steuerbarer Feldeffekttransistor geschaltet. Wenn der Steuerstrom in der Rücksetzschleife "LOW" ist, dann ist der Feldeffekttransistor hochohmig und die Spannung am Speicherkondensator C10 entspricht dem Spitzenwert der angelegten Wechselspannung. Führt die Stromschleife einen Steuerstrom, dann wird der Feldeffekttransistor niederohmig und entlädt den Speicherkondensator C10. Gleichzeitig wird der Eingang von U6B kurzgeschlossen. Der Meßzyklus sollte dabei max. 0,5 s nicht überschreiten. Die Entladungszeit sollte mindestens 20 µs betragen. Während der Entladung werden keine Spitzenspannungen erfaßt. Parallel zum RST-Eingang ist weiterhin eine Surpressordiode als Schutz vor Überspannungen vorgesehen. Entsprechende Prinzipschaltungen möglicher Schalteranordnungen sind auf Seite 719 des weiter oben genannten Fachbuches beschrieben. Die hier erläuterte Sample- and Hold-Schaltung weist zwei Schaltelemente auf. Der in der Figur 4 links dargestellte Schalter U1 dient zum Abschalten der Eingangsspannung über die Drain-Source-Strecke, der rechts dargestellte Schalter U2 dient zum Kurzschließen des Speicherkondensators C10.

Fig. 5 zeigt einen Ausschnitt einer nachgeordneten Ausgangsschaltung.
Für beide Arten der parallelen Signalverarbeitung sind diese Ausgangsschaltungen gleich. Als Stromquellenschaltkreis kann besonders vorteilhaft ein IC vom Typ AD694, ebenfalls hergestellt von der Fa. Analog Devices, USA. Er ist beschrieben in der Firmendruckschrift "4-20 mA Transmitter AD694, den US-Patentschriften RE 30.586, 4.250.445 und 4.857.862.
Der Stromausgang ist jeweils zur Begrenzung von auf den Ausgang eingekoppelten Spannungen mit einer Supressordiode beschaltet, die die maximale Spannung am Ausgang begrenzt. Diese Ausgangsschaltung läßt einen Anschluß von Bürdenwiderständen in der Stromschleife bis zu einem Gesamtwert von ca. 500 Ω zu.

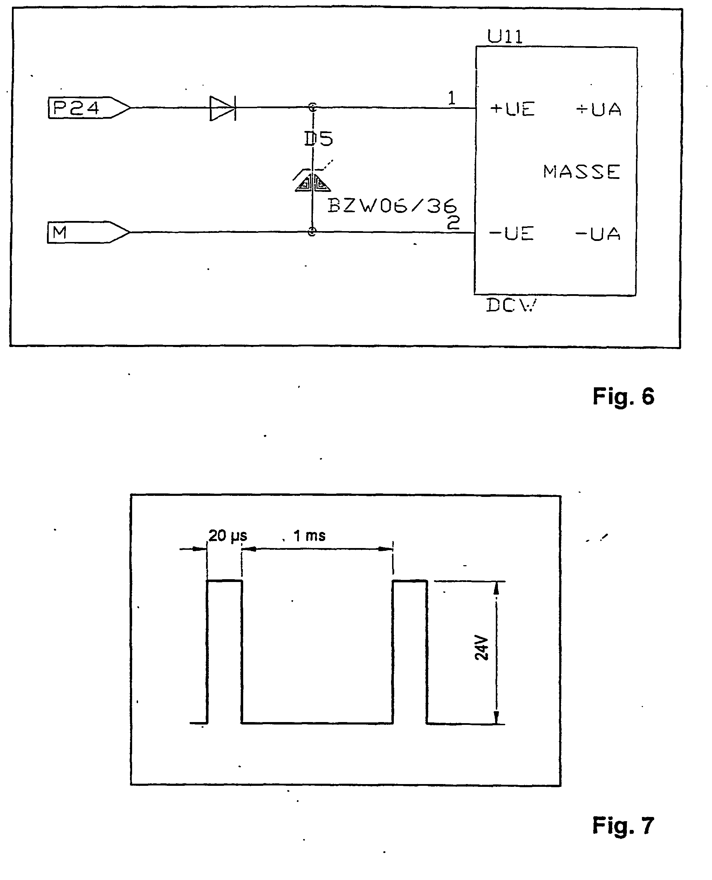

Fig. 6 zeigt den Teil der Stromversorgung. Dabei ist wiederum parallel zum Eingang eine Supressordiode geschaltet.

Fig. 7 schließlich zeigt einen typischen Rücksetzimpuls, wie er, erzeugt durch nachgeordnete, hier nicht näher dargestellte Auswerte- oder Monitoringgeräte, auf den Eingang der in Fig. 4 dargestellten und weiter oben bereits erläuterten Speicher- und Rücksetzschaltung gegeben wird.

Insgesamt dienen das erfindungsgemäße Meßverfahren sowie die erfindungsgemäße Meßanordnung damit zur Umsetzung von einer an einem kapazitiven Teiler anliegenden Spannung in einen dem Effektivwert dieser Spannung einerseits und weiterhin dem Spitzenwert dieser Spannung andererseits jeweils entsprechenden Ausgangsstrom. Gespeichert wird dabei - im Gegensatz zum Stand der Technik - eben auch der größte Betrag der auftretenden Spitzenspannung während eines Meßintervalles. Über einen Rücksetzeingang kann - wie erläutert - dabei die Dauer des Meßintervalles bestimmt und festgelegt werden, indem der Spitzenwertspeicher zurückgesetzt wird. Die gesamte Meßanordnung weist dabei nur kleine und kleinste elektronische Bauelemente und Baugruppen auf, die auf wenigen Leiterplatten, Einschüben o.ä. unterzubringen sind, gegenüber dem Stand der Technik ist der Platzbedarf um Größenordnungen geringer - ebenso wie das Gewicht.

## Patentansprüche

1. Meßverfahren für eine an einer Hochspannungsdurchführung eines Transformators anliegende Spannung, von der für jede Phase über einen kapazitiven Hochspannungsteiler jeweils eine Teilspannung als Eingangsspannung abgegriffen wird,
**dadurch gekennzeichnet,**
**daß** die Eingangsspannung zunächst einer Pegelanpassung mit nachfolgender Spannungsbegrenzung zum Schutz vor Überspannungen unterworfen wird,
**daß** nachfolgend eine Potentialtrennung erfolgt und anschließend eine parallele Weiterverarbeitung des Wertes der Eingangsspannung in zwei getrennten und unabhängigen Kanälen erfolgt,
**daß** im ersten Kanal eine Betragsbildung des Wertes der Eingangsspannung erfolgt, dieser Wert anschließend einer Sample- and Hold-Schaltung zugeführt wird, die ihrerseits einen Stromquellenschaltkreis ansteuert, derart, daß der Ausgangsstrom dieses Stromquellenschaltkreises einen Wert ergibt, der proportional dem Spitzenwert der Eingangsspannung ist
und **daß** im zweiten Kanal eine Gleichrichtung erfolgt und der erhaltene Wert der Eingangsspannung einen weiteren Stromquellenschaltkreis ansteuert, derart, daß der Ausgangsstrom dieses weiteren Stromquellenschaltkreises einen Wert ergibt, der proportional dem Effektivwert der Eingangsspannung ist.

2. Meßanordnung für eine an einer Hochspannungsdurchführung eines Transformators anliegende Spannung, von der für jede Phase über einen kapazitiven Hochspannungsteiler jeweils eine Teilspannung als Eingangsspannung abgegriffen wird,
**dadurch gekennzeichnet,**
**daß** eine Eingangsschaltung vorgesehen ist, die auf an sich bekannte Weise zur Pegelanpassung und Spannungsbegrenzung zum Schutz vor Überspannungen dient,
**daß** der Ausgang dieser Eingangsschaltung zu Mitteln zur Potentialtrennung führt,
**daß** der Ausgang der Mittel zur Potentialtrennung zu zwei getrennten parallelen Verarbeitungskanälen führt,
**daß** der erste Verarbeitungskanal Mittel zur Betragsbildung aufweist, deren Ausgang mit dem Eingang einer Sample- and Hold-Schaltung in Verbindung steht, wobei der Ausgang der Sample- and Hold-Schaltung an den Eingang eines Stromquellenschaltkreises geschaltet ist, dessen Ausgangsstrom einen Wert darstellt, der proportional zum Spitzenwert der Eingangsspannung ist
und **daß** der zweite Verarbeitungskanal Mittel zur Gleichrichtung aufweist, deren Ausgang an den Eingang eines weiteren Stromquellenschaltkreises geschaltet ist, dessen Ausgangsstrom einen Wert darstellt, der proportional zum Effektivwert der Eingangsspannung ist.

3. Meßanordnung nach Patentanspruch 2,
**dadurch gekennzeichnet,**
**daß** ein Isolationstrennverstärker als Mittel zur Potentialtrennung dient.

## Claims

1. Measuring method for a voltage which lies at a high-voltage lead-through of a transformer and from which for each phase a respective part voltage as input voltage is tapped by way of a capacitive high-voltage divider, **characterised in that** the input voltage is initially subjected to level matching with subsequent voltage limiting for protection against over-voltages, that subsequently a potential separation takes place and then a parallel processing of the value of the input voltage in two separate and independent channels, that in the first channel an amount formation of the value of the input voltage takes place and this value is subsequently fed to a sample-and-hold circuit which in tum controls a current source circuit in such a manner that the output current of this current source circuit yields a value proportional to the peak value of the input voltage and that in the second channel a rectification takes place and the obtained value of the input voltage controls a further current source circuit in such a manner that the output current of this further current source circuit yields the value which is proportional to the effective value of the input voltage.

2. Measuring arrangement for a voltage which lies at a high-voltage lead-through of a transformer and from which for each phase a respective part voltage as input voltage is tapped by way of a capacitive high-voltage divider, **characterised in that** an input circuit is provided which serves in a manner known per se for level matching and voltage limiting for protection against over-voltages, that the output of this input circuit leads to means for potential separation, that the output of the means for potential separation leads to two separate, parallel processing channels, that the first processing channel comprises means for amount formation, the output of which is connected with the input of a sample-and-hold circuit, wherein the output of the sample-and-hold circuit is connected with the input of a current source circuit, the output current of which represents a value proportional to the peak value of the input voltage, and that the second processing channel comprises means for rectification, the output of which is connected with the input of a further current source circuit, the output current of which represents a value proportional to the effective value of the input voltage.

3. Measuring arrangement according to claim 2, **characterised in that** an isolation separating amplifier serves as means for potential separation.

## Revendications

1. Procédé de mesure d'une tension appliquée à une traversée de haute tension d'un transformateur selon lequel, pour chaque phase on détecte une tension partielle comme tension d'entrée chaque fois par un diviseur de haute tension capacitif,
**caractérisé en ce qu'**
on soumet la tension d'entrée tout d'abord à une adaptation de niveau suivie d'une limitation de tension pour se protéger contre les surtensions,
ensuite on effectue une séparation de potentiel et ensuite une poursuite du traitement en parallèle de la valeur de la tension d'entrée dans deux canaux distincts et indépendants,
dans le premier canal, on forme l'amplitude de la valeur de la tension d'entrée puis, on fournit cette valeur à un circuit d'échantillonnage et de maintien qui à son tour commande un circuit de source de courant de façon que le courant de sortie de ce circuit donne une valeur proportionnelle à la valeur maximale de la tension d'entrée, et
dans le second canal, on fait un redressement et la valeur obtenue pour la tension d'entrée commande un autre circuit de source de courant de façon que le courant de sortie de cet autre circuit de source de courant donne une valeur proportionnelle à la valeur effective de la tension d'entrée.

2. Installation de mesure d'une tension appliquée à une traversée de haute tension d'un transformateur, et qui pour chaque phase détecte une tension divisée comme tension d'entrée par un diviseur de haute tension capacitif,
**caractérisée en ce qu'**
un circuit d'entrée sert de manière connue en soi à protéger contre les surtensions par une adaptation de niveau et une limitation de tension, la sortie de ce circuit d'entrée conduit à des moyens de séparation de potentiel,
la sortie des moyens de séparation de potentiel conduit à deux canaux de traitement parallèles, distincts,
le premier canal de traitement comporte des moyens pour former une amplitude dont la sortie est reliée à l'entrée d'un circuit d'échantillonnage et de maintien,
la sortie de ce circuit d'échantillonnage et de maintien étant reliée à l'entrée d'un circuit de source de courant dont le courant de sortie représente une valeur proportionnelle à la valeur maximale de la tension d'entrée, et
le second canal de traitement comporte des moyens de redressement dont la sortie est reliée à l'entrée d'un autre circuit de source de courant dont le courant de sortie correspond à une valeur proportionnelle à la valeur effective de la tension d'entrée.

3. Dispositif de mesure selon la revendication 2,
**caractérisé par**
un amplificateur séparateur d'isolation comme moyen de séparation de potentiel.
